# EUROPÄISCHE PATENTSCHRIFT

(11) **EP 1 182 914 B1**
(45) Veröffentlichungstag und Bekanntmachung des Hinweises auf die Patenterteilung: **11.04.2007**
(21) Anmeldenummer: 01115953.0
(22) Anmeldetag: 29.06.2001
(51) Int. Cl.: H05K 7/20

(54) **Elektronische Ansteuerung für Heizelemente**
Electronic control for a heating element
Commande électronique d'un élément chauffant

(30) Priorität: 23.08.2000 DE 10041417
(43) Veröffentlichungstag der Anmeldung: 27.02.2002
(73) Patentinhaber: Beru AG, 71636 Ludwigsburg (DE)
(72) Erfinder: Geiger, Steffen, c/o Beru AG, 71636 Ludwigsburg (DE); Giffels, Thomas, c/o Beru AG, 71636 Ludwigsburg (DE); Neckel, Klaus, c/o Beru AG, 71636 Ludwigsburg (DE)
(74) Vertreter: Wilhelms, Rolf E.

(56) Entgegenhaltungen:
- DE-A- 3 829 117
- GB-A- 2 258 563
- US-A- 5 508 885
- PATENT ABSTRACTS OF JAPAN vol. 009, no. 310 (E-364), 6. Dezember 1985 (1985-12-06) & JP 60 145647 A (FUJITSU KK), 1. August 1985 (1985-08-01)

## Beschreibung

Die Erfindung betrifft ein Verfahren zur Leitung der Betriebswärme eines üblichen Halbleiterschalters zu einem von diesem angesteuerten Heizelement sowie ein solches Heizelement.

Zum Schalten hoher Ströme werden üblicherweise Halbleiter(HL)-Schalter verwendet, die im wesentlichen aus einem Schaltergehäuse und einem in diesem angeordneten Halbleiterchip bestehen. Durch den Innenwiderstand dieser HL-Schalter entsteht Verlustleistung in Form von Wärme. Bei Ansteuerung von Heizelementen wird üblicherweise versucht, diese Wärme in das Medium zu leiten, das durch das Heizelement aufgeheizt werden soll. Dieses geschieht durch spezielle Kühlkörper, die zusätzlich zum eigentlichen Heizelement in dem zu heizenden Medium plaziert werden.

Nachteilig an diesen Lösungen ist der Umstand, daß zur Kühlung der HL-Schalter zusätzliche Bauteile, wie die erwähnten Kühlkörper, verwendet werden. Diese Kühlkörper müssen zusätzlich zum Heizelement in dem zu heizenden Medium plaziert werden. Dadurch wirken die Kühlkörper gegenüber dem eigentlichen Heizelement als sekundäres Heizelement mit daraus resultierender inhomogener Temperatur- und Druckverteilung. Darüberhinaus wird durch die zusätzlichen Bauelemente mehr Bauraum benötigt, wobei gleichzeitig zusätzliche Material- und Montagekosten auftreten.

Aufgabe der Erfindung ist es, den Wärmetransport vom Halbleiterschalter zur eigentlichen Heizzelle zu bewirken, die Anzahl der benötigten mechanischen Bauelemente zu verringern und Aufbau und Montage einer solchen Anordnung zu vereinfachen.

Erfindungsgemäß wird diese Aufgabe durch das Verfahren nach Anspruch 1 und das Heizelement nach Anspruch 2 gelöst; weitere vorteilhafte Ausgestaltungen der Erfindung ergeben sich aus den nachfolgenden Ansprüchen 3 und 4.

Die Erfindung wird anhand der folgenden Figuren näher erläutert. Hierbei zeigt
Fig. 1 schematisch die Seitenansicht einer erfindungsgemäßen Anordnung;
Fig. 2 die Draufsicht auf die Ausführungsform einer erfindungsgemäßen Anordnung gemäß Fig. 1.

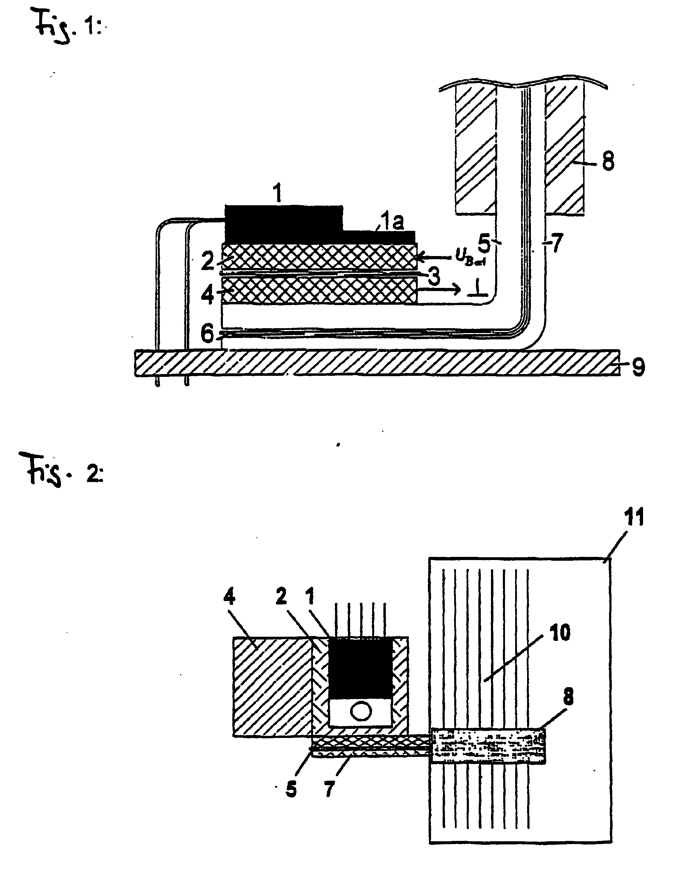

Anhand der Figuren 1 und 2 soll das erfindungsgemäße Verfahren und das erfindungsgemäße Heizelement prinzipiell beschrieben werden. Hierbei wird ein Standardhalbleiterschalter 1 mit Kühlfahne 1a in handelsüblicher Form, also mit Gehäuse, auf einem stromleitenden Materialstreifen 2, der mit der Versorgungsspannung verbunden ist, unmittelbar und in direktem Kontakt aufgebracht; dieses geschieht bevorzugt dadurch, daß der stromleitende Materialstreifen 2 als Stanzbiegeteil ausgebildet wird, auf den der HL-Schalter 1 mit seiner Kühlfahne 1a aufgelötet wird.

Dieses Bauteil 2 ist über eine Schraub-, Klemm, Steck-, Press-, Schweiß- oder Lötverbindung mit U_{Bat} verbunden. Über Bauteil 2 wird der HL-Schalter mit der Versorgungsspannung versorgt; gleichzeitig transportiert er die im HL-Schalter entstehende Wärme weiter über eine wärmeleitende Isolierfolie 3 auf den wärme- und stromleitenden Materialstreifen 4. Die Isolierfolie 3 stellt sicher, daß zwischen dem Streifen 2 und dem Materialstreifen 4, der bevorzugt ebenfalls als Stanzbiegeteil ausgebildet ist, kein elektrischer Kurzschluß entstehen kann. Die thermische Leitfähigkeit dieser Isolierfolie 3 soll sehr hoch sein, damit die Verlustleistung des HL-Schalters vom Materialstreifen 2 auf Materialstreifen 4 mit geringst möglichem Verlust weitergeleitet werden kann. Als geeignetes Material für Isolierfolie 3 sei eine keramische Wärmeleitfolie, beispielsweise Kerafol WLF 86/74, mit einer Wärmeleitfähigkeit λ = 1,8 W/mK und eine Dicke von etwa 0,2 mm genannt.

Das Bauteil 4 ist über eine Schraub-, Klemm-, Steck-, Press-, Schweiß- oder Lötverbindung mit Masse verbunden.

Der wärme- und stromleitende Materialstreifen 4 liegt unmittelbar, diesen kontaktierend, auf dem Masseanschluß 5 auf; wobei 5 wiederum bevorzugt als Stanzbiegeteil ausgebildet ist. Diese Bauteil 5 ist über eine Schraub-, Klemm-, Steck-, Press-, Schweiß- oder Lötverbindung mit der eigentlichen Heizzelle 8 des Heizelements 11 verbunden. Bei der Heizzelle 8 handelt es sich bevorzugt um PTC-Heizelemente.

Bauteil 5 ist mit der Heizzelle 8 auf diese Weise elektrisch und thermisch verbunden, so daß das Massepotential und gleichzeitig die im HL-Schalter entstandene Wärme an oder in die Heizzelle 8 geleitet werden.

Die in der Heizzelle 8 angeordneten bevorzugten PTC-Elemente werden über die Heizzelle 8 (Heizrohr) mit Massepotential versorgt.

An der Heizzelle 8 befinden sich Kühllamellen 10, über die die Wärme vom HL-Schalter 1 zuzüglich zu der Heizwärme der PTC-Elemente an das zu heizende Medium abgegeben werden. Schalter 1 mit Leitungsstreifen, Wärmebrücke und Isolierschichten, Heizzelle 8 und Kühllamellen 10 bilden gemeinsam das Heizelement 11. In die Heizzelle 8 führt ebenso der Kontaktstreifen 7, über den die PTC-Elemente mit U_{Bat} kontaktiert werden; Kontaktstreifen 7 ist gegenüber dem Masseanschluß 5 durch die Isolierfolie 6 isoliert; als Isolierfolie 6 kann beispielsweise eine Kaptonfolie verwendet werden; die geeignete Dicke liegt bei etwa 0,05 mm und die Wärmeleitfähigkeit bei etwa λ = 0,76 W/mK. Bevorzugt wird der Kontaktstreifen 7 zusammen mit den Stanzbiegeteilen 2, 4, 5 und den Isolationsfolien 3, 6 als Paket auf eine Leiterplatte 9 gepreßt.

Bevorzugt wir der Kontaktstreifen 7 über die Leiterplatte 9 und die Anschlußdrähte des Halbleiterschalters 1 mit U_{Bat} beschaltet.

Die bevorzugt als Stanzbiegeteile ausgebildeten Bauteile 2, 4, 5 sind vorzugsweise aus Elektrokupfer gefertigt, weil dieses eine gute elektrische und thermische Leitfähigkeit gewährleistet; als geeignetes Material sei beispielsweise Elektrokupfer mit einer Wärmeleitfähigkeit λ ≈ 400 W/mK und einer Dicke von 1,0 mm und mehr genannt. Der bevorzugte etwa 0,6 mm dicke Materialstreifen 7 besteht aus vernickeltem Messing, mit dem die PTC-Bausteine im Heizrohr gut und dauerhaft kontaktiert werden können.

Das erfindungsgemäße Verfahren ist einfach und wirkungsvoll; das auf diese Weise ausgebildete Heizelement benötigt weniger Bauteile, ist einfach und kostengünstig herzustellen und raumsparend ausbildbar.

## Patentansprüche

1. Verfahren zur Leitung der Betriebswärme eines üblichen Halbleiterschalters zu einer, von dieser angesteuerten Heizzelle, **dadurch gekennzeichnet, daß** man einen Standardhalbleiterschalter (1) mit Kühlfahne (1a) unmittelbar auf einen wärme- und stromleitenden Materialstreifen (2), der mit der Versorgungsspannung verbunden ist, aufbringt, wobei der Streifen (2) auf einem wärme- und stromleitenden Materialstreifen (4) mit zwischenliegender wärmeleitender Isolierfolie (3) aufliegt, wobei der Materialstreifen (4) unmittelbar auf dem Materialstreifen (5) als Masseanschluß zur Heizzelle (8) des Heizelements (11) aufliegt, der wiederum auf dem streifenförmigen Stromversorgungsanschluß (7) mit zwischenliegender wärmeleitender Isolierfolie (6) aufliegt.

2. Heizelement, das von einem Standardhalbleiterschalter angesteuert ist, **dadurch gekennzeichnet, daß** der Standardhalbleiterschalter (1) mit Kühlfahne (1a) unmittelbar auf einem wärme- und stromleitenden Materialstreifen (2), der mit der Versorgungsspannung verbunden ist, aufgebracht ist, wobei der Streifen (2) auf einen wärme- und stromleitenden Materialstreifen (4) mit zwischenliegender wärmeleitender Isolierfolie (3) aufliegt, wobei der Materialstreifen (4) unmittelbar auf dem Masseanschluß (5) zur Heizzelle (8) des Heizelements (11) aufliegt, der wiederum auf dem streifenförmigen Stromversorgungsanschluß (7) mit zwischenliegender wärmeleitender Isolierfolie (6) aufliegt.

3. Heizelement nach Anspruch 2, **dadurch gekennzeichnet, daß** die Materialstreifen (2), (4) und (5) aus Elektrokupfer bestehen.

4. Heizelement nach Anspruch 3, **dadurch gekennzeichnet, daß** der Materialstreifen (7) aus vernickeltem Messing besteht.

## Claims

1. A method for conducting the process heat from a conventional semiconductor circuit to a heating cell that is controlled by said process heat, **characterised in that** a standard semiconductor circuit (1) having a cooling vane (1 a) is applied directly to a thermally and electrically conductive strip of material (2) which is connected to the power supply voltage, the strip (2) resting upon a thermally and electrically conductive strip of material (4) with a thermally conductive insulating foil (3) interposed therebetween; the strip of material (4) rests directly on the strip of material (5) acting as an earth connection to the heating cell (8) of the heating element (11), which in turn is resting on the strip-like power supply connection (7) with its interposed thermally conductive insulating foil (6).

2. A heating element which is controlled by a standard semiconductor circuit, **characterised in that** the standard semiconductor circuit (1) with its cooling vane (1a) is applied directly to a thermally and electro-conductive strip of material (2) which is connected to the power supply voltage, the strip (2) resting upon a thermally and electrically conductive strip of material (4) with a thermally conductive insulating foil (3) interposed therebetween; the strip of material (4) rests directly on the earth connection (5) to the heating cell (4) of the heating element (11), which in turn is resting on the strip-like power supply connection (7) with its interposed thermally conductive insulating foil (6).

3. The heating element according to claim 2, **characterised in that** the strips of material (2), (4) and (5) are made from electrolytic copper.

4. The heating element according to claim 3, **characterised in that** the strip of material (7) is made from nickel-plated brass.

## Revendications

1. Procédé pour conduire la chaleur de fonctionnement d'un interrupteur à semi-conducteur habituel vers une cellule chauffante commandée par celui-ci, **caractérisé en ce que** l'on applique un interrupteur à semi-conducteur standard (1) à ailette de refroidissement (1a) directement sur une bande de matériau thermo- et électroconductrice (2) qui est connectée à la tension d'alimentation, la bande (2) s'appliquant sur une bande de matériau thermo- et électroconductrice (4) ayant une feuille isolante thermoconductrice intermédiaire (3), dans lequel la bande de matériau (4) s'applique directement sur la bande de matériau (5) comme connexion de terre vers la cellule chauffante (8) de l'élément chauffant (11) qui s'applique à son tour sur la connexion d'alimentation en courant (7) en forme de bande avec une feuille isolante thermoconductrice intermédiaire (6).

2. Elément chauffant qui est commandé par un interrupteur à semi-conducteur standard, **caractérisé en ce que** l'interrupteur à semi-conducteur standard (1) à ailette de refroidissement (1a) est appliqué directement sur une bande de matériau thermo- et électroconductrice (2) qui est connectée à la tension d'alimentation, dans lequel la bande (2) s'applique sur une bande de matériau thermo- et électroconductrice (4) avec une feuille isolante thermoconductrice intermédiaire (3), la bande de matériau (4) s'appliquant directement sur la connexion de terre (5) vers la cellule chauffante (8) de l'élément chauffant (11), connexion de terre qui s'applique à son tour sur la connexion d'alimentation en courant (7) en forme de bande avec une feuille isolante thermoconductrice intermédiaire (6).

3. Elément chauffant selon la revendication 2, **caractérisé en ce que** les bandes de matériau (2), (4) et (5) sont constituées de cuivre de qualité électrique.

4. Elément chauffant selon la revendication 3, **caractérisé en ce que** la bande de matériau (7) est constituée de laiton nickelé.
